# EUROPEAN PATENT APPLICATION

(11) **EP 1 834 933 A1**
(43) Date of publication of application: **19.09.2007**
(21) Application number: 05806558.2
(22) Date of filing: 18.11.2005
(51) Int. Cl.: C03C 17/22, C23C 16/30

(54) **PROCESS FOR PRODUCING GLASS PLATE WITH THIN FILM**

(30) Priority: 19.11.2004 JP 2004336515
(71) Applicant: Nippon Sheet Glass Company, Limited, Tokyo 105-8552 (JP)
(72) Inventor: OTANI, Tsuyoshi, NIPPON SHEET GLASS COMPANY, LTD, Tokyo 105-8552 (JP); YOSHIDA, Hidemasa, NIPPON SHEET GLASS COMPANY, LTD, Tokyo 105-8552 (JP); ARAI, Daisuke, NIPPON SHEET GLASS COMPANY, LTD, Tokyo 105-8552 (JP); FUJISAWA, Akira, NIPPON SHEET GLASS COMPANY, LTD, Tokyo 105-8552 (JP)
(74) Representative: Hubert, Philippe
(86) International application number: PCT/JP2005/021306
(87) International publication number: WO 2006/054730

(57) **Abstract**

A method of manufacturing a glass sheet with a thin film, having a titanium compound as its main component formed on the glass sheet, which is a manufacturing method preventing deterioration in quality of the thin film, such as incorporating an impurity or forming a pinhole and enables an excellent productivity, is provided. The method is a manufacturing method that supplies a coating film forming gas including a titanium containing compound, a nitrogen containing compound and an oxidizing gas, on a surface of a glass sheet or a glass ribbon in a process of manufacturing a glass sheet at a temperature equal to or higher than a predetermined temperature and forms a thin film having titanium oxynitride, nitrogen doped titanium oxide or titanium nitride as its main component on the surface. Otherwise, the method is a manufacturing method that forms a thin film having titanium nitride as its main component on the surface, by supplying a coating film forming gas including a titanium containing compound and a nitrogen containing compound. In this method, the coating film forming gas further includes a reaction inhibitor that inhibits a chemical reaction between the titanium containing compound and the nitrogen containing compound at the time before the gas reaches to the surface.

## Description

### Technical Field

The present invention relates to a method of manufacturing a glass sheet with a thin film by chemical vapor deposition (CVD), more specifically to a method of manufacturing a glass sheet with a surface on which a thin film having at least one titanium compound selected from nitrogen doped titanium oxide, titanium oxynitride and titanium nitride as its main component is formed.

### Background Art

As examples of a thin film having a titanium compound as its main component formed on a glass sheet, a titanium oxide film (a TiO₂ film) having titanium oxide as its main component, a titanium nitride film (a TiN film) having titanium nitride as its main component, a titanium oxynitride film (a TiON film) having titanium oxynitride as its main component and a nitrogen doped titanium oxide film (a TiO₂:N film) having a nitride doped titanium oxide as its main component are known.

### (TiO₂ Film)

TiO₂ films have specific optical properties, such as a high refractive index or light transmittance having wavelength dependence, for example transmitting visible light but reflecting ultraviolet and infrared light, and it also have excellent light resistance and chemical resistance. Taking advantage of these properties, TiO₂ films are used widely for adding a heat ray reflection property to a glass sheet and improving weather resistance and chemical resistance in a glass sheet. In recent years, much attention has been drawn to creation of hydrophilicity, anti-fogging property, self purifying property and the like to a glass sheet surface using the photocatalytic reaction of TiO₂ films.

### (TiN Film)

TiN films are known for their extremely high hardness and their excellent stability, and they are widely employed for materials for tool tips, wiring substrates for semiconductor devices and the like taking advantage of these properties. TiN films also have an optical property, of absorbing near infrared light and light with longer wavelength than that, and have been utilized increasingly as a thin film for controlling solar energy.

### (TiON Film and TiO₂:N Film)

Various applications are available for films made of a titanium compound including oxygen and nitrogen depending on their nitrogen content. TiON films, which have relatively high nitrogen content, are expected to use the intermediate optical properties in between those of TiO₂ films and TiN films. On the other hand, much attention has been drawn to TiO₂:N films, which have relatively low nitrogen content and have nitrogen as a so-called doping agent, as one of the materials that act as a photocatalyst reacting to visible light. For example, in JP2003-190815 A, a technique to make a photocatalyst reacting to light in the visible range by replacing at least a part of oxygen sites in a TiO₂ film with nitrogen atoms is disclosed. Since the photocatalytic reactions by the TiO₂ films are developed generally by irradiating light with a wavelength of equal to or lower than 380 nm approximately (ultraviolet light), TiO₂ films can not effectively use light in the visible range largely contained in sunlight and artificial lightings, such as a fluorescent light. Thus, it is expected that a photocatalyst reacting to visible light enables an effective use of optical energy.

### [Film Forming Techniques]

As methods for forming a thin film having these titanium compounds as its main components on a glass sheet, sputtering, spraying or chemical vapor deposition (CVD) are known.

### (Sputtering)

Sputtering is a type of vacuum deposition, and it is a technique employed in a wide range of fields. A thin film formed by sputtering generally has a favorable thickness distribution (having a high uniformity in film thickness).

TiO₂ may be employed for a target in order to form a TiO₂ film by sputtering. In order to form a TiN film, TiN may be employed for a target, or reactive sputtering may be carried out employing metal titanium for a target under a nitrogen containing atmosphere. Methods for forming a TiON film or a TiO₂:N film on a glass sheet by sputtering are disclosed, for example in JP2001-205103 A.

### (Spraying)

Spraying is a method for forming a thin film by spraying a raw material solution including thin film materials onto a heated substrate. It is a characteristic of spraying that it can be carried out with relatively simple facilities.

### (CVD)

Techniques for forming a TiO₂ film by CVD are disclosed in many references. For example, in JP2001-503005 A, a method of forming a TiO₂ film on a surface of a substrate by bringing the substrate into contact with a gas mixture including titanium tetrachloride (TiCl₄) as a titanium source and an organic oxygen containing compound, such as ester, as an oxygen source is disclosed. For another example, in JP2003-501338 A, a method for forming a TiO₂ film on a surface of a substrate by bringing the substrate into contact with a fluid mixture including a titanium source and an oxygen source is disclosed. As the oxygen source in this method, organic oxygen containing compounds, such as ester, are shown similarly to the method of JP2001-503005 A.

A technique for forming a TiN film by CVD is disclosed, for example in JP59(1984)-502062 A. According to the publication, a TiN film can be deposited on the glass substrate by mixing a gas including titanium tetrachloride and a gas including ammonia very close to a glass substrate.

CVD is excellent in mass production of a glass sheet with a thin film. For example, it is relatively easy to integrate CVD into glass sheet manufacturing processes, such as a glass sheet manufacturing line by a float process (a float glass manufacturing line), and CVD easily can form a thin film onto a glass sheet having a large area.

### (Another Method of Manufacturing a TiON Film and a TiO₂:N Film)

Another method of manufacturing a TiON film or a TiO₂:N film, which is different from CVD and is not sputtering, is disclosed in JP2003-190815 A mentioned above. According to the publication, a TiON film or a TiO₂:N film can be formed by forming a TiO₂ film on a substrate by a technique, such as sol-gel, and then nitriding the formed TiO₂ film. As a process of nitriding in this case, a method of heating at temperatures in a range from 400°C to 1200°C for one minute to 120 minutes, preferably at temperatures in a range from 500°C to 700°C for five minutes to 60 minutes, under an atmosphere including ammonia, nitrogen and the like is disclosed.

Each conventional technique mentioned above, however, has problems on forming each thin film of a titanium compound as described below.

### (TiON Film and TiO₂:N Film)

The sputtering disclosed in JP2001-205103 A requires large-scale vacuum facilities, and there is a concern that the film forming facilities themselves have an enormous cost.

The method disclosed in JP2003-190815 A requires a treatment in two steps, which are forming a TiO₂ film and nitriding the formed TiO₂ film, and a plurality of steps that require such different treatment environments causes an increase in manufacturing costs. In addition, this nitridation is time consuming because it utilizes nitrogen diffusion from a thin film surface, and thus it is difficult to secure mass productivity and make the nitrogen content constant along with the direction of thickness of the thin film.

Neither a TiON film nor a TiO₂:N film was obtained by the techniques disclosed in the other publications above.

### (TiN Film)

Since the method disclosed in JP59(1984)-502062 A uses titanium tetrachloride and ammonia, which have reactivity as high as reacting to each other and forming a solid reaction product at room temperature, it requires mixing raw material gasses including each substance very close to a glass substrate on which a TiN film is formed. However, when gasses are mixed very close to a glass substrate, the composition and the film thickness of the formed thin film tend to be nonuniform.

On the other hand, when the raw material gasses are mixed in advance to be made into a coating film forming gas, the reaction of titanium tetrachloride and ammonia may progress in a pipe supplying the coating film forming gas and a reaction product may be deposited in the pipe, which causes a piping blockage. In addition, if the product is transported to a surface of the glass sheet by flow of the raw material gasses, it is taken in by the thin film being formed, which causes development of defects such as a pinhole. JP59(1984)-502062 A discloses that the formation of a reaction product can be inhibited by making the temperature of the raw material gasses in a range from 200°C to 400°C under a condition of a titanium tetrachloride concentration within a range from 0.1 mol% to 0.5 mol%.

### (TiO₂ Film)

The methods disclosed in JP2001-503005 A and JP2003-501338 A may cause a carbon component included in an ester compound, which is an oxygen source, to be taken in by a thin film being formed, and may deteriorate the quality of the thin film.

### (Spraying)

When using a spraying method, it is difficult to control the size or the velocity of sprayed droplets and, moreover, to remove the parts not forming a film, such as an unreacted component and a reaction side product, of the raw material solution to the outside of the system. Thus, an obtained thin film tends to have nonuniform thickness, and this tendency becomes stronger as the area size of a glass sheet that a thin film to be formed on becomes larger.

It is an object of the present invention to provide a method of manufacturing a glass sheet with a thin film, having a titanium compound as its main component formed on the glass sheet, which is a manufacturing method preventing deterioration in quality of the thin film, such as incorporating an impurity or forming a pinhole, and enabling an excellent productivity, particularly a productivity when forming a thin film on a glass sheet having a large area.

### Disclosure of Invention

A first method of manufacturing a glass sheet with a thin film according to the present invention is a method of forming a thin film having titanium oxynitride as its main component (a TiON film), a thin film having nitrogen doped titanium oxide as its main component (a TiO₂:N film) or a thin film having titanium nitride as its main component (a TiN film), by supplying a coating film forming gas including a titanium containing compound, a nitrogen containing compound and an oxidizing gas, on a surface of a glass sheet or a glass ribbon in a process of manufacturing a glass sheet at a temperature equal to or higher than a predetermined temperature.

According to the first method, a glass sheet with a thin film having a TiON film, a TiO₂:N film or a TiN film formed on the glass sheet can be manufactured with high productivity while preventing deterioration in the quality of the thin film, such as incorporating an impurity or forming a pinhole.

In the first method, which one of a TiON film, a TiO₂:N film or a TiN film is formed on the surface of the glass sheet or the glass ribbon is determined mainly by a ratio of a content of the oxidizing gas to a content of the titanium containing compound in the coating film forming gas, and a TiN film can be formed when the ratio is less than a predetermined value A₁, a TiO₂:N film can be formed when the ratio is equal to or more than a predetermined value A₂, which is greater than the value A₁, and a TiON film can be formed when the ratio is equal to or more than the value A₁ and less than the value A₂.

A second method of manufacturing a glass sheet with a thin film according to the present invention is a method of forming a thin film having titanium nitride as its main component (a TiN film), by supplying a coating film forming gas including a titanium containing compound and a nitrogen containing compound, on a surface of a glass sheet or a glass ribbon in a process of manufacturing a glass sheet at a temperature equal to or higher than a predetermined temperature. In this method, the coating film forming gas further includes a reaction inhibitor that inhibits a chemical reaction between the titanium containing compound and the nitrogen containing compound at the time before the gas reaches to the surface.

According to the second method, a glass sheet with a thin film having a TiN film formed on the glass sheet can be manufactured with high productivity while preventing deterioration in quality of the thin film, such as incorporating an impurity or forming a pinhole.

The first and the second methods can be integrated into glass sheet manufacturing processes, such as a float glass manufacturing line. When the first and the second methods are thus integrated, it becomes possible to continuously produce glass sheets each having a large area on which a TiON film, a TiO₂:N film and/or a TiN film is formed.

According to the first and the second methods, it becomes possible to make the nitrogen content almost constant along with the direction of the thickness of the thin film by controlling the manufacturing conditions.

Here, the nitrogen doped titanium oxide (TiO₂:N) in the present description means a compound that has titanium as cations, oxide ions as anions and a part of the oxide ions are substituted by nitride ions, and the TiO₂ crystal structure can be observed by a structure analysis using X-ray diffraction. The Ti-O bonds can be observed by a structure analysis according to the X-ray Photoelectron Spectroscopy (ESCA), but the Ti-N bonds cannot be observed in some cases depending on the nitrogen content.

The titanium oxynitride (TiON) means a compound that has titanium as cations and includes both oxide ions and nitride ions as anions, and it does not have a specific crystal structure but is amorphous. The titanium oxynitride is not limited to compounds satisfying a stoichiometric mixture ratio (stoichiometric compounds), but it includes compounds out of the stoichiometric mixture ratio. In other words, the titanium oxynitride in the present description can be defined as a stoichiometric or nonstoichiometric compound represented by the formula TiOₓN_{y} (0<x, y). The structure analysis according to ESCA can observe the Ti-N bonds as well as the Ti-O bonds.

The titanium nitrogen (TiN) means a compound that has titanium as cations and includes an oxide ion or a nitride ion, respectively, as an anion, and it does not have a specific crystal structure but is amorphous. Similar to TiON, this compound does not necessarily satisfy a stoichiometric mixture ratio. The structure analysis according to ESCA can observe the Ti-N bonds.

The titanium containing compound, the nitrogen containing compound and the oxidizing gas that are included in the coating film forming gas become origins of titanium ions, nitride ions and oxide ions, respectively, in a thin film formed by the manufacturing method of the present invention.

The main component in the present description means a component included the most in a formed thin film. According to the manufacturing method of the present invention, a film having a 100 weight% content of the component in a formed thin film, i.e. a thin film consists of the component, can be formed.

### Brief Description of Drawings

Fig. 1 is a schematic view illustrating an example of a glass sheet with a thin film formed by the manufacturing method of the present invention.
Fig. 2 is a schematic view illustrating another example of a glass sheet with a thin film formed by the manufacturing method of the present invention.
Fig. 3 is a schematic view illustrating an example of an apparatus with which the manufacturing method of the present invention can be carried out.

### Best Mode for Carrying Out the Invention

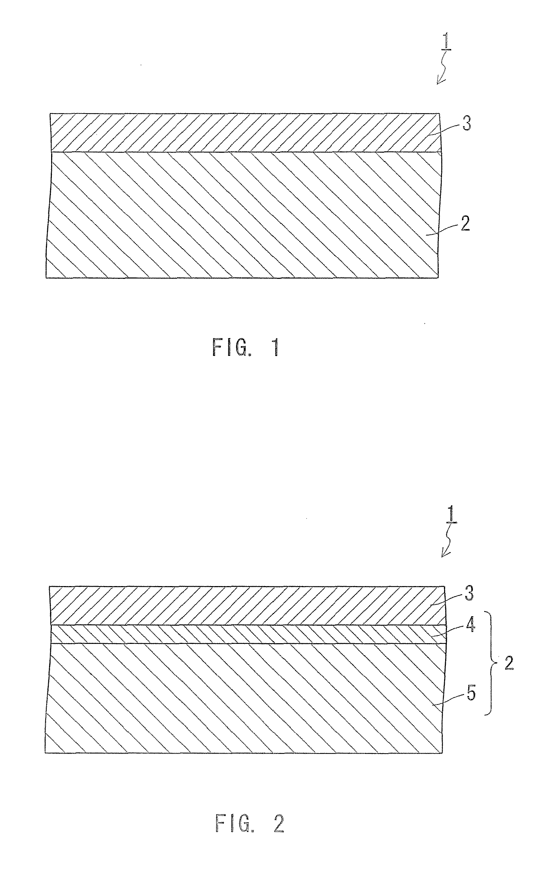

An example of a glass sheet with a thin film obtained by the manufacturing method of the present invention is shown in Fig. 1. A glass sheet with a thin film 1 shown in Fig. 1 has a thin film 3 made of a TiON film, a TiO₂:N film or a TiN film formed on a surface of a glass sheet 2 as a substrate. The thin film 3 can be formed by the manufacturing method of the present invention as described above. The manufacturing method of the present invention includes both the first and the second manufacturing methods.

Another example of a glass sheet with a thin film obtained by the manufacturing method of the present invention is shown in Fig. 2. A glass sheet with a thin film 1 shown in Fig. 2 has a thin film 3 formed on a surface of a glass sheet 2, which is provided with a base film 4. The types of the base film 4 are not particularly limited, and it may be a film, for example, capable of functioning as an alkali barrier. The alkali component may affect the thin film 3 depending on the type of thin film 3, and for example, a TiO₂:N film tends to lower the photocatalysis performance by the alkali component. Even when the glass sheet 1 includes an alkali component, such as a soda lime glass, the unfavorable influence of the alkali component transfer on the thin film 3 can be prevented by forming the thin film 3 via the base film 4 as shown in Fig. 2.

Examples of a film capable of functioning as an alkali barrier may be a single layer of silicon dioxide (SiO₂), silicon tin oxide (SnSiO), silicon oxycarbide (SiOC), silicon carbide (SiC), silicon nitride (SiN), silicon oxynitride (SiON) or tin oxide (SnO₂) and a stacked film of these materials. These materials do not necessarily satisfy a stoichiometric mixture ratio. That is, similar to the titanium oxynitride (TiON), the silicon oxynitride may be described as a stoichiometric or nonstoichiometric compound satisfying the formula SiOₓN_{y} (0<x, y), and it is expressed as SiON in the present description. Similarly, silicon tin oxide, silicon oxycarbide, silicon carbide and silicon nitride are expressed as SnSiO, SiOC, SiC and SiN, respectively, in the present description.

The glass sheet with a thin film 1 shown in Fig. 2 can be obtained by forming the thin film 3 according to the manufacturing method of the present invention on the surface of the glass sheet 2, after forming the glass sheet 2 as a substrate by forming the base film 4 by a known method, such as CVD, sputtering and spraying, on the surface of the glass sheet 5.

The composition of the glass sheet 2 (5) is not particularly limited, and it may be selected suitably according to an intended use of the glass sheet with a thin film 1, for example soda lime glass, which is generally employed for architectural and vehicle purposes, non-alkali glass and silica glass.

### (Method of Forming the Thin Film 3)

The thin film 3 may be formed on a surface of the glass sheet 2 by CVD. The type of CVD is not particularly limited, but due to the easy integration into glass sheet manufacturing processes such as a float glass manufacturing line, it is preferred to form the thin film 3 by thermal CVD, particularly thermal CVD under atmospheric pressure. The CVD enables forming a thin film 3 with a more uniform film thickness even on a glass sheet 2 having a large area by controlling the manufacturing conditions.

The thermal CVD can be carried out, for example, by heating the glass sheet 2 of a predetermined size and then spraying the coating film forming gas onto a surface of the heated glass sheet 2. More specifically, for example, it may be carried out by transporting the glass sheet 2 into a furnace by a transport mechanism such as a mesh belt, heating it to a predetermined temperature in the furnace and supplying the coating film forming gas in the furnace while the glass sheet 2 is maintained at the temperature. The coating film forming gas is reacted by the heat of the surface of the glass sheet 2, and a thin film is formed on the glass sheet 2 (off-line film deposition).

The formation of the thin film 3 by thermal CVD also may be carried out during a step of forming a glass sheet from a glass melt (a forming step) or a step of annealing after forming into a sheet shape in a glass sheet manufacturing process (an online film deposition). Since the glass sheet 2 has a high temperature during these steps, the heating facilities for the glass sheet 2 to deposit a thin film can be omitted. In addition, this method enables fast film deposition onto a glass sheet having a large area, and a glass sheet with a thin film employed for uses requiring a large area, such as architectural and vehicle purposes, can be manufactured with high productivity.

The temperature of the glass sheet 2 upon forming the thin film 3 is preferably equal to or more than 600°C. That is, it is preferable to form a thin film on a surface of the glass sheet or the glass ribbon in a process of manufacturing a glass sheet at a temperature equal to or higher than 600°C. The upper limit of the temperature is, in the case of a soda lime glass for example, at about 1000°C.

The preferable range of the temperature is dependent on factors such as the required film deposition rate, but it is preferred to be in a range approximately from 500°C to 850°C.

### (Example of CVD during the Forming Step - In-Bath CVD)

As a forming step of a glass sheet, forming by floating is widely practiced. In a float process, a glass melt formed in a melting furnace (a float furnace) is made to flow into a molten tin basin (a float bath) to form a glass sheet. The glass melt flows out of the float furnace is stretched into a seamless long sheet in a ribbon-like shape in the molten tin basin, and a glass in this state is defined as a glass ribbon.

It is possible to form the thin film 3 according to the manufacturing method of the present invention by thermal CVD in the float bath (in-bath CVD). In addition to the advantages described above, the in-bath CVD has the following characteristics. Firstly, a float bath originally has a structure that prevents the air coming in as much as possible, and the atmosphere inside the bath is under control. Thus, it can protect better against developing defects, such as incorporating an impurity or forming a pinhole, in the thin film to be formed. Secondly, a temperature of a glass ribbon in a float bath is extremely high, and the temperature varies depending on the composition of a glass ribbon. For example, in a case of a common soda lime glass, it is in a range from 650°C to 1150°C, approximately. Thus, it becomes possible to enhance the reactivity of the coating film forming gas, and this enables enhancing the film deposition rate of the thin film 3 or enlarging the ranges of composition of the thin film to be formed. The temperature of the glass ribbon may be measured by a radiation thermometer.

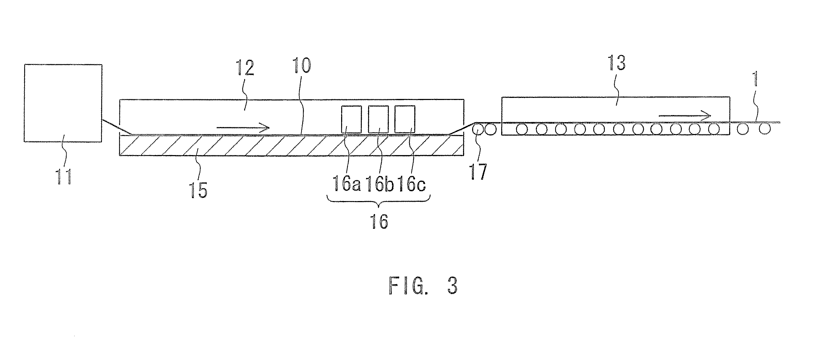

An example of an apparatus that can form a thin film 3 on a surface of a glass ribbon by in-bath CVD is shown in Fig. 3. As shown in Fig. 3, in this apparatus, a predetermined number of coaters 16 are set in a float bath 12 at a predetermined distance from a surface of a glass ribbon 10 flowing out from a float furnace 11 into the float bath 12 and moving on molten tin 15 in a ribbon shape. Although three coaters 16a, 16b and 16c set along the traveling direction of the glass ribbon 10 are indicated in the example shown in Fig. 3, the number and the layout of coaters 16 can be determined suitably according to the type and the thickness of the thin film 3 to be formed. Supplying the coating film forming gas from the coaters 16 enables continuous formation of the thin film 3 on the glass ribbon 10. The temperature of the glass ribbon 10 may be controlled by a heater and a cooler (not shown) set in the float bath 12 in order to be at a predetermined temperature right before the coaters 16. The glass ribbon 10 having the thin film 3 formed thereon is lifted up by rollers 17 to be sent out to an annealing lehr (a lehr) 13. A glass sheet with a thin film 1 after annealing in the lehr 13 may be fabricated into a glass sheet in predetermined shape and size by a general purpose processor, such as a cutting apparatus.

### (Example of CVD during the Annealing Step - In-Lehr CVD)

It is possible to form the thin film 3 according to the manufacturing method of the present invention by thermal CVD in the lehr 13 (in-lehr CVD). The in-lehr CVD may set the coaters 16 as shown in Fig. 3 at an entrance where the glass ribbon 10 formed in the float bath 12 is introduced into the lehr 13 and/or inside of the lehr 13, and may supply the coating film forming gas from the coaters 16 into the lehr 13. Although the glass ribbon 10 at the neighboring area of the entrance of the lehr 13 and at the inside of the lehr 13 is lower in temperature compared to the glass ribbon 10 in the float bath 12, it has a temperature high enough to form the thin film 3. The in-lehr CVD has the following characteristics, different from the in-bath CVD. Firstly, it can stably manufacture a glass sheet with a thin film 1 even when the coating film forming gas includes a raw material gas inadequate for the in-bath CVD, such as raw material gases having a too high reaction rate at the temperature of the glass ribbon 10 in the float bath 12 and raw material gases that may contaminate the inside of the float bath 12 (typically the molten tin 15). Secondly, it enables application to glass sheet manufacturing processes without floating. For example, integrating into a glass sheet manufacturing process by rolling out enables an easy manufacture of a figured glass, a wire glass, a line wire glass and the like on which the thin film 3 is formed.

When the coaters 16 are set inside the lehr 13, the position to set the coaters 16 may be decided according to the temperature of the glass ribbon 10 in the lehr 13. The temperature of the glass ribbon 10 at the place where the coaters 16 are set can be the film deposition temperature. For example, when a high temperature is required for forming the thin film 3, the coaters 16 may be set at the neighboring area of the entrance of the lehr 13.

Accordingly, the manufacturing method of the present invention can be a manufacturing method that is integrated easily into glass sheet manufacturing processes, such as a float glass manufacturing line, and that is excellent in productivity compared to when a thin film is formed by sputtering or spraying.

### (Coating Film Forming Gas)

According to the first manufacturing method of the present invention, the coating film forming gas includes one or more types of titanium containing compound as a raw material for titanium, one or more types of nitrogen containing compound as a raw material for nitrogen and one or more types of oxidizing gas as a raw material for oxygen.

### (Titanium Containing Compound)

The type of the titanium containing compound is not particularly limited, and it may be either a titanium containing inorganic compound or a titanium containing organic compound. However, titanium containing inorganic compounds free from carbon are preferable to improve further the quality of the thin film to be formed. Titanium halide is a typical titanium containing inorganic compound. In a case of a titanium containing organic compound, at least one selected from titanium alkoxide and a titanium chelate compound may be employed, for example.

The titanium containing compound is preferably in a form of gas or liquid at ordinary temperature, and it is preferable to have its boiling point lower when it is liquid at ordinary temperature. These preferred titanium containing compounds can be a component of the coating film forming gas without any treatment or by heating for evaporation. Even when a compound is in a solid form at ordinary temperature, sublimable compounds or compounds dissoluble in an organic solvent such as alcohol and toluene, preferably can be employed for the titanium containing compound.

Examples of such titanium containing compound may be titanium tetrachloride (TiCl₄) as a type of titanium halide, a titanium ethoxide (Ti(OC₂H₅)₄), a titanium isoproxide (Ti(OC₃H₇)₄) or a titanium normal butoxide (Ti(OC₄H₉)₄) as a type of titanium alkoxide or a titanium acetylacetonato ((C₃H₇O₂)₂Ti(C₅H₇O₂)₂) as a type of a titanium chelate compound. Among these, titanium tetrachloride is preferable because it is excellent in reactivity when forming a thin film and it can improve the film deposition rate.

### (Titanium Tetrachloride Content)

When employing titanium tetrachloride as the titanium containing compound, a titanium tetrachloride content (concentration) X₁ in the coating film forming gas is preferably equal to or more than 0.1 mol%, more preferably equal to or more than 0.5 mol%, and further preferably more than 0.5 mol% and equal to or more than 1 mol%, in this order. When the content X₁ is within the range, the film deposition rate can be improved, for example, as good as equal to or more than 10 nm/second, or it can be even equal to or more than 20 nm/second or equal to or more than 24 nm/second depending on a manufacturing condition. Thus, a thin film 3 having a sufficient thickness can be formed easily even in a case of an online film deposition.

In addition, in the manufacturing method of the present invention, the content X₁ also can be more than 1 mol%, for example 3 mol%, depending on a manufacturing condition, such as a condition in which the coating film forming gas includes a reaction inhibitor described below. It is difficult for conventional manufacturing methods to make the titanium tetrachloride content so large in order to inhibit a reaction (a gas phase reaction) between the titanium tetrachloride and the nitrogen containing compound at the time before the coating film forming gas reaches to a surface of the glass substrate for forming a thin film.

### (Nitrogen Containing Compound)

The type of the nitrogen containing compound is not particularly limited, and it may be at least one selected from ammonia (NH₃), various amines and hydrazine derivatives, for example. Among all, it is preferable to employ ammonia because it is introduced easily into the coating film forming gas due to having a gas form at normal temperature under normal pressure, it is easy to handle due to the easy condensation by compression and it is available at low cost in a large amount. Although amines and hydrazine derivatives cost more than ammonia, they are excellent in reactivity when forming a thin film and they enable an easy manufacture of a high quality thin film.

When employing titanium tetrachloride as the titanium containing compound, a nitrogen containing compound is preferably ammonia. Since titanium tetrachloride and ammonia can react in a wide range of mixture ratios, the contents of Ti (titanium), N (nitrogen) and O (oxygen) in the thin film can be controlled through a wider range when forming a TiON film.

When the coating film forming gas includes titanium tetrachloride as a titanium containing compound and ammonia as a nitrogen containing compound, a ratio B (X₂/X₁) of an ammonia content X₂ to a titanium tetrachloride content X₁ in the coating film forming gas is generally equal to or more than 0.001, preferably equal to or more than 0.005 and more preferably equal to or more than 0.009.

### (Oxidizing Gas)

The type of the oxidizing gas is not particularly limited, and it may include at least one selected from, for example, oxygen (O₂), carbon dioxide (CO₂), carbon monoxide (CO) and water (H₂O). Compared to a case in which organic esters are employed for the oxidizing gas as in JP2001-503005 A, defects in a thin film, such as forming a pinhole, can be prevented. Among these, due to an excellent reactivity when forming a thin film, which leads to improving the film deposition rate, the oxidizing gas preferably includes at least one selected from water and oxygen, and more preferably includes oxygen.

Air can be employed as the oxidizing gas, and the nitrogen (N₂) included in the air can serve as a reaction diluent, in this case.

When titanium tetrachloride is employed for a titanium containing compound, the oxidizing gas is preferably oxygen.

For the first manufacturing method, it is preferred to employ titanium tetrachloride for the titanium containing compound, ammonia for the nitrogen containing compound and oxygen for the oxidizing gas.

### (Mixture Ratio of Each Raw Material)

A TiO₂:N film can be formed on a surface of a glass sheet or a glass ribbon (hereinafter, also referred to simply as "a glass substrate") when a ratio A (X₃/X₁) of an oxygen content X₃ to a titanium tetrachloride content X₁ in the coating film forming gas is equal to or more than 0.4 expressed as a molar ratio in a case that the titanium containing compound is titanium tetrachloride and the oxidizing gas includes oxygen. The upper limit of the molar ratio is not particularly limited, and for example, is 20.

When the coating film forming gas does not include the reaction inhibitor described below, the molar ratio A is preferably equal to or more than 1, more preferably equal to or more than 3 and further preferably equal to or less than 9. In this case, it can prevent problems such as generating a solid reaction product in the coating film forming gas and blocking a pipe, and thus it becomes possible to deposit a high quality thin film more stably.

The upper limit of a ratio B (X₂/X₁) of a titanium tetrachloride content X₁ to an ammonia content X₂ in the coating film forming gas is not particularly limited, and for example, is 20. When it is put into a practical phase of forming a TiO₂:N film, the molar ratios A and B may be determined according to a film composition developing required properties as a TiO₂:N film.

Since this method does not require a plurality of steps that require different treatment environments, for example nitriding after forming a TiO₂ film as the method disclosed in JP2003-190815 A, it can be a manufacturing method with excellent productivity.

A TiON film can be formed on a surface of a glass sheet or a glass ribbon (hereinafter, also referred to simply as "a glass substrate") when a ratio A (X₃/X₁) of an oxygen content X₃ to a titanium tetrachloride content X₁ in the coating film forming gas is equal to or more than 0.1 and less than 0.4 expressed as a molar ratio in a case that the titanium containing compound is titanium tetrachloride and the oxidizing gas includes oxygen.

In order to form a TiON film more stably, it is preferred that the coating film forming gas includes ammonia as the nitrogen containing compound and a ratio B (X₂/X₁) of an ammonia content X₂ to a titanium tetrachloride content X₁ in the coating film forming gas is equal to or more than 1.3, and it is more preferred that the ratio B is more than 9, each ratio B expressed as a molar ratio. The upper limit of the ratio B is not particularly limited, and for example, is 20. When it is put into a practical phase of forming a TiON film, the molar ratios A and B may be determined according to a film composition developing required properties as a TiON film, and for example, the nitrogen content in the TiON film to be formed can be higher as the molar ratio B becomes larger.

Since this method does not require a plurality of steps that require different treatment environments, for example nitriding after forming a TiO₂ film as the method disclosed in JP2003-190815 A, it can be a manufacturing method with excellent productivity.

A TiN film can be formed on a surface of a glass sheet or a glass ribbon (hereinafter, also referred to simply as "a glass substrate") when a ratio A (X₃/X₁) of an oxygen content X₃ to a titanium tetrachloride content X₁ in the coating film forming gas is less than 0.1 expressed as a molar ratio in a case that the titanium containing compound is titanium tetrachloride and the oxidizing gas includes oxygen. The lower limit of the molar ratio A is not particularly limited, and for example, is 0.001, preferably 0.005 and more preferably 0.05.

In order to form a TiN film more stably, it is preferred that the coating film forming gas includes ammonia as the nitrogen containing compound and that a ratio B (X₂/X₁) of an ammonia content X₂ to a titanium tetrachloride content X₁ in the coating film forming gas is preferably more than 9 expressed as a molar ratio. The upper limit of the ratio B is not particularly limited, and for example, is 20.

Conventional methods of forming a TiN film by CVD supply a coating film forming gas made of a titanium containing compound and a nitrogen containing compound to the surface of a glass substrate. At this point, a solid reaction product tends to be formed by reaction (gas phase reaction) of a titanium containing compound and a nitrogen containing compound in a pipe supplying the coating film forming gas. When the product is transported to a surface of the glass substrate by flow of the coating film forming gas, it is taken in by the thin film being formed, which causes development of defects such as a pinhole. In addition, the titanium containing compound is consumed by the reaction, and it may result in lowering the film deposition rate of the thin film.

In contrast, the first manufacturing method of the present invention can inhibit reaction of a titanium containing compound and a nitrogen containing compound in a pipe and the like by an oxidizing gas included in a coating film forming gas less than a predetermined value A₁, and thus a TiN film in which development of defects such as a pinhole are prevented more can be formed.

The predetermined values A₁ and A₂ vary depending on the types of titanium containing compound, oxidizing gas and nitrogen containing compound.

### (Reaction Inhibitor)

In the first manufacturing method of the present invention, the coating film forming gas may include a reaction inhibitor that inhibits a chemical reaction between the titanium containing compound and the nitrogen containing compound at the time before the gas reaches to a surface of the glass sheet or the glass ribbon.

When a thin film is formed by CVD on an industrial scale, each component included in a coating film forming gas generally is supplied through a pipe from a storage tank such as a gas cylinder to a surface of a glass substrate on which the coating film forming gas is reacted. At this point, a reaction (a gas phase reaction) of them may progress before the coating film forming gas reaches to the surface of the substrate depending on the combination of the titanium containing compound and the nitrogen containing compound. When a gas phase reaction progresses, a solid reaction product is developed in the coating film forming gas and it causes blocking a pipe and inhibiting a stable formation of a thin film due to interference of the flow of the coating film forming gas, as described above. In addition, if the reaction product is transported to a surface of the substrate, it is taken in by the thin film being formed, which causes development of defects such as a pinhole. Thus, the reaction inhibitor also can be described as a material inhibiting this gas phase reaction, and the inclusion of the reaction inhibitor in the coating film forming gas enables to form a TiON film stably, a TiO₂:N film or a TiN film higher in quality.

Since the reaction inhibitor can inhibit the gas phase reaction, each content (concentration) of the titanium containing compound and the nitrogen containing compound in the coating film forming gas can be heightened, and thus the film deposition rate of the thin film can be more improved. The effect of improving the film deposition rate of the thin film is particularly outstanding in the online film deposition in which the time available for film deposition is more limited.

The gas phase reaction is particularly likely to progress when titanium tetrachloride is employed for the titanium containing compound and ammonia for the nitrogen containing compound. Thus, it is preferable to include further a reaction inhibitor when the coating film forming gas includes titanium tetrachloride and ammonia.

The material employed for a reaction inhibitor is not particularly limited as long as it can inhibit the gas phase reaction, and hydrogen chloride can be employed, for example. Hydrogen chloride effectively can inhibit the gas phase reaction even when the coating film forming gas includes titanium tetrachloride and ammonia.

When hydrogen chloride further is added to the coating film forming gas including ammonia as a reaction inhibitor, it is preferred to mix hydrogen chloride and the raw material gases except ammonia first and then to mix ammonia. This is because hydrogen chloride and ammonia easily react and form ammonium chloride when they are mixed without dilution, and the formed ammonium chloride is taken in by the thin film being formed, which can cause development of defects such as a pinhole. By mixing hydrogen chloride and the raw material gases except ammonia in advance, the hydrogen chloride is diluted and thus formation of ammonium chloride when mixing ammonia can be inhibited.

Although the principle of inhibiting a gas phase reaction between titanium tetrachloride and ammonia by a reaction inhibitor is not yet clearly figured out, a possible explanation is as follows.

When the coating film forming gas includes ammonia and hydrogen chloride, they react easily and form a reaction product. When depositing a thin film, the temperature at the part where titanium tetrachloride and ammonia are mixed in the pipe supplying the coating film forming gas is generally in a range from 200°C to 400°C approximately. In such a temperature range, the reaction product is considered to be in a gas form and the reaction product itself is not likely to be deposited inside the pipe. In addition, as a result of forming the reaction product, the ammonia concentration in the coating film forming gas becomes lowered and thus it is considered that the gas phase reaction between titanium tetrachloride and ammonia can be inhibited.

According to the reasoning, ammonia is transported to a surface of the glass substrate as a reaction product with hydrogen chloride. Since the temperature on the surface of the glass substrate is in a range from 600°C to 1000°C, it is considered that the reaction product is decomposed and thus molecular ammonia is formed. It is, then, considered that the formed ammonia reacts with the titanium tetrachloride included in the coating film forming gas to deposit a thin film including nitrogen and titanium. Here, it is also possible to consider that the deposited thin film is oxidized immediately depending on the amount of oxidizing gas when the oxidizing gas is included in the coating film forming gas and thus a thin film including titanium, nitrogen and oxygen can be formed.

### (Amount of Reaction Inhibitor to be Added)

When the content of the reaction inhibitor is too large in the coating film forming gas, the reaction between a titanium containing compound and a nitrogen containing compound on the surface of the glass substrate is sometimes inhibited similarly and the film deposition rate may be lowered. For this reason, a ratio C (X₄/X₁) of a hydrogen chloride content X₄ to a titanium tetrachloride content X₁ in the coating film forming gas is defined as less than 20 expressed as a molar ratio.

The molar ratio C is preferably equal to or less than 15, and more preferably equal to or less than 2. The lower limit of the molar ratio C is not particularly limited, but preferably equal to or more than 0.005 and more preferably equal to or more than 0.05.

When the coating film forming gas includes a reaction inhibitor, it enables to enlarge the content of the nitrogen containing compound in the coating film forming gas, and thus the film deposition rate can be improved, for example. Specifically, when the coating film forming gas includes ammonia as a nitrogen containing compound and hydrogen chloride as a reaction inhibitor, the ratio B (X₂/X₁) of an ammonia content X₂ to a titanium tetrachloride content X₁ in the coating film forming gas may be more than 9 expressed as a molar ratio. Even in this case, the ratio C (X₄/X₁) of a hydrogen chloride content X₄ to a titanium tetrachloride content X₁ in the coating film forming gas is defined as less than 20 expressed as a molar ratio.

### (Supplying the Coating Film Forming Gas)

The coating film forming gas may be supplied to the surface of the glass substrate after mixing each component or in each component separately, for example, from two or more of the coaters as shown in Fig. 3. It is preferably supplied after mixing each component in order to form a thin film of higher quality having less variation in composition and thickness.

The coating film forming gas also may be supplied onto the surface of the glass substrate after being diluted to an adequate concentration for forming a thin film by an inert gas, such as nitrogen and helium.

When the coating film forming gas is supplied onto the surface of the glass substrate after mixing each component, the temperature of the gas is preferably in a range from 200°C to 400°C, more preferably in a range from 250°C to 300°C in order to inhibit a gas phase reaction inside a pipe, for example, at the time before the gas reaches to the surface. Maintaining the temperature of the coating film forming gas in the range enables inhibiting the gas phase reaction particularly between titanium tetrachloride and ammonia. The temperature of the coating film forming gas can be controlled, for example, by keeping the temperature of the pipe within the range.

Particles having TiCl₄ nNH₃ as their main component are easily formed when the temperature of the coating film forming gas is less than 200°C, particles having TiNCl as their main component are easily formed when the temperature of the gas is more than 400°C and particles having TiN as their main component are easily formed when the temperature of the gas is more than 500°C, each as products of the gas phase reaction.

### (Second Manufacturing Method)

According to the second manufacturing method of the present invention, the coating film forming gas includes one or more types of titanium containing compound as a raw material for titanium, one or more types of nitrogen containing compound as a raw material for nitrogen and a reaction inhibitor. The reaction inhibitor functions to inhibit a chemical reaction between the titanium containing compound and the nitrogen containing compound at the time before the coating film forming gas reaches a surface of a glass sheet or a glass ribbon.

The types of the titanium containing compound, the nitrogen containing compound and the reaction inhibitor, the content and the mixture ratio of each component in the coating film forming gas and the preferable combination of each component may be the same as the first manufacturing method of the present invention.

Since the coating film forming gas includes the reaction inhibitor according to the second manufacturing method of the present invention, it does not need to mix the titanium containing compound and the nitrogen containing compound very close to the surface of the glass substrate, as the method disclosed in JP59(1984)-502062 A. Thus, a TiN film having the composition and the thickness more uniform can be formed.

### (Pretreatment of the Glass Sheet)

According to the first manufacturing method of the present invention, the surface of the glass substrate preferably is pretreated before forming a thin film. The pretreatment enables further improving the film deposition rate of a thin film.

An example of the pretreatment may be a treatment of heating the surface of the glass substrate on which a thin film is to be formed and spraying a nitrogen containing compound, such as ammonia, onto the heated surface. The pretreatment thus can improve the film deposition rate of a TiON film, TiO₂:N film and a TiN film. Although the mechanism of enabling improvement of the film deposition rate of each film by such pretreatment is not yet clearly figured out, the present inventors considering the following possibility.

Firstly, the nitrogen containing compound makes contact with the surface and it is decomposed by the heat to form a nitrogen containing intermediate. Although the formed nitrogen containing intermediate is considered to absorb on the surface, the intermediate reacts with a titanium containing compound continuously supplied to the surface due to the high reactivity to the titanium containing compound, and TiON, TiO₂:N or TiN is formed easily. Since the nitrogen containing intermediate is absorbing to the surface at this point, TiON, TiO₂:N or TiN formed by the reaction remains on the surface to compose a TiON film, a TiO₂:N film or a TiN film, respectively. In this way, the film deposition rate of each film is considered to be improved.

As another pretreatment different from the above, a catalytic member may be placed, for example at a position on the surface of the glass substrate right before the coating film forming gas is supplied, adjacent to the surface. This pretreatment enables improving the film deposition rate of each film, such as a TiON film. An example of the catalytic member to be placed may be an electrically heated tungsten wire. Since a nitrogen containing intermediate is formed by making contact between a catalytic member and a nitrogen containing compound when the catalytic member is placed, the film deposition rate of each film, such as a TiON film, is considered to be improved similar to the example above.

### Examples

Hereinafter, the present invention is described further in detail with the Examples.

### (Example 1)

A non-alkali glass sheet with a thickness of 0.7 mm is cut into a square of 10 cm on each side, and it is cleaned and dried. On one surface of this glass sheet, a TiON film is formed by an apparatus for thermal CVD under atmospheric pressure. A specific procedure is shown below.

First, the glass sheet was transported to a furnace maintained at 650°C by a mesh belt and then heated. After sufficiently heating the glass sheet in the furnace, a coating film forming gas (gas temperature at about 250°C) including titanium tetrachloride as a titanium containing compound, ammonia as a nitrogen containing compound and oxygen as an oxidizing gas was supplied on the surface, the opposite side from the mesh belt, of the glass sheet and a thin film was formed on the surface to fabricate a glass sheet with a thin film. The mixture ratio of each component in the supplied coating film forming gas was titanium tetrachloride:ammonia:oxygen = 1:9.1:0.16 expressed as a molar ratio, and the titanium tetrachloride concentration was 0.5 mol%. The speed of the mesh belt, which is the transportation system for the glass sheet, was controlled while forming the thin film in order to have the thickness of the formed thin film at 50 nm. The thickness of the thin film was obtained by observing the cross section through a scanning electron microscope (SEM). This method of measuring the thickness of the thin film was the same in the Examples and the Comparative Examples below. In addition, the speed of the mesh belt was identical in the Examples and the Comparative Examples below except the Examples by in-bath CVD. That is, it can be concluded that the thicker the formed thin film was, the larger the film deposition rate of the thin film in the Example was.

Next, an extinction coefficient was evaluated as an optical property of the formed thin film, and the extinction coefficient at the wavelength of 600 nm was 0.57. Since an extinction coefficient at the wavelength was almost 0 when a thin film is made of TiO₂:N film, the formed thin film was considered as a TiON film. Spectroscopic ellipsometry was employed for evaluating the extinction coefficient of a thin film in order to obtain a value of the thin film itself without including the glass sheet.

Then, the composition of the surface of the formed thin film was analyzed by employing the X-ray Photoelectron Spectroscopy (ESCA). A peak (a binding energy of 396 eV) considered to be derived from a Is electron of N (nitrogen) that was bonded to Ti (titanium) was observed through paying attention to the binding energy of the Is shell of N, and it was found that Ti-N bonds were formed in the thin film. After that, a peak was observed near the binding energy of 459 eV through paying attention to the binding energy of a 2P_{3/2} shell of Ti, and the obtained spectral chart had a proximate shape to the chart of TiO₂. By these results, it was observed that the thin film included both Ti-N bonds and Ti-O bonds and it was a TiON film.

The ESCA measurement was carried out without ion etching on the thin film surface. It is common to remove contaminants attached onto the sample surface by a technique such as ion etching before ESCA measurement. The thin film formed in the present Example, however, was not ion etched because there was a possibility of reducing the surface by ion etching. The method of composition analysis of the thin film surface by ESCA was the same in the Examples and the Comparative Examples below.

### (Example 2)

A thin film was formed on a surface of a glass sheet in the same manner as the Example 1 other than the temperature of the furnace, i.e. the temperature of the glass sheet surface (a film deposition temperature) at 600°C and the mixture ratio of each component in the coating film forming gas as titanium tetrachloride:ammonia:oxygen = 1:9.1:0.35 expressed as a molar ratio. The thickness of the formed thin film was 50 nm.

An extinction coefficient of the thin film was evaluated in the same manner as the Example 1, and it was 0.43 at the wavelength of 600 nm. The composition was also analyzed by ESCA as the Example 1, and it was observed that the thin film included both Ti-N bonds and Ti-O bonds and it was a TiON film.

### (Example 3)

A TiON film was formed on a surface of a glass ribbon by in-bath CVD employing the apparatus shown in Fig. 3. A specific procedure is shown below.

First, raw materials were melted in the float furnace 11 and a glass melt of soda lime glass was formed. Following to this, the glass melt having a temperature controlled in a range from 1100°C to 1150°C was flown into the float bath 12, and it was formed into a glass ribbon 10 having a thickness of 4 mm while cooling. At this point, a coating film forming gas was supplied from the second coater (the coater 16b in Fig. 3) onto a surface (a surface opposite from the molten tin 15) of the glass ribbon 10 by setting the coater at a position where the temperature of the glass ribbon 10 was 680 ± 5°C, and thus a thin film (a thickness of 30 nm) was formed on the surface. A gas of titanium tetrachloride, ammonia and oxygen diluted by nitrogen gas was employed for the coating film forming gas. The mixture ratio of each component in the coating film forming gas was as titanium tetrachloride:ammonia:oxygen = 1:9.1:0.2 expressed as a molar ratio, and the titanium tetrachloride concentration was 0.3 mol%. The temperature of a pipe supplying the coating film forming gas was at 250°C.

An extinction coefficient of the formed thin film was evaluated in the same manner as the Example 1, and it was 0.51 at the wavelength of 600 nm. The composition was also analyzed by ESCA as the Example 1, and it was observed that the thin film included both Ti-N bonds and Ti-O bonds and it was a TiON film.

### (Example 4)

A thin film was formed on a surface of a glass sheet in the same manner as the Example 1 other than the mixture ratio of each component in the coating film forming gas as titanium tetrachloride:ammonia:oxygen = 1:9.1:0.6 expressed as a molar ratio. The thickness of the formed thin film was 50 nm.

An extinction coefficient of the thin film was evaluated in the same manner as the Example 1, and it was almost 0 at the wavelength of 600 nm and a TiO₂:N film was formed. The composition also was analyzed by ESCA as the Example 1, and it was observed that the thin film included both Ti-N bonds and Ti-O bonds.

Results of the Examples 1 to 4 are shown in Table 1 below.

**TABLE 1**

| | Mixture Ratio of each Component in Coating Film Forming Gas (Molar Ratio where TiCl₄ is 1) | | | TiCl₄ Concentration in Coating Film Foaming Gas (mol%) | Film Deposition Temperature (°C) | Film Thickness (nm) | Type of Thin Film | Linear Attenua tion Coefficient (at 600 nm) |
|---|---|---|---|---|---|---|---|---|
| | NH₃ | O₂ | HCl | | | | | |
| Example 1 | 9.1 | 0.16 | 0 | 0.5 | 650 | 50 | TiON | 0.57 |
| Example 2 | 9.1 | 0.35 | 0 | 0.5 | 600 | 50 | TiON | 0.43 |
| Example 3 | 9.1 | 0.2 | 0 | 0.3 | 680 | 30 | TiON | 0.51 |
| Example 4 | 9.1 | 0.6 | 0 | 0.5 | 650 | 50 | TiO₂:N | Almost 0 |

### (Example 5)

A thin film was formed on a surface of a glass sheet in the same manner as the Example 1 other than the film deposition temperature at 750°C, the coating film forming gas further including hydrogen chloride, with the mixture ratio of each component in the coating film forming gas as titanium tetrachloride:ammonia:oxygen:hydrogen chloride = 1:0.09:9.1:0.05 expressed as a molar ratio and the titanium tetrachloride concentration as 1 mol%. The thickness of the formed thin film was 35 nm. The coating film forming gas was fabricated by mixing the components except ammonia in advance and then adding ammonia.

The composition of the formed thin film was analyzed by ESCA as the Example 1, and the thin film included both Ti-N bonds and Ti-O bonds and the content of N atom forming the Ti-N bond in the thin film was 0.2 atom%.

Next, the formed thin film was structurally analyzed by X-ray diffraction, and an anatase TiO₂ crystal structure was observed. Based on these results, it was determined that a TiO₂:N film was formed.

As a result of continuous supply of the coating film forming gas over eight hours to the apparatus for thermal CVD under atmospheric pressure after forming the thin film as above, no significant change was found in the gas pressure in the pipe supplying the coating film forming gas. In addition, the pipe was taken apart to observe the inside after stopping the supply of the coating film forming gas, and no deposit was found in the pipe.

### (Example 6)

A thin film was formed on a surface of a glass sheet in the same manner as the Example 5 other than the mixture ratio of each component in the coating film forming gas as titanium tetrachloride:ammonia:oxygen:hydrogen chloride = 1:0.9:9.1:0.05 expressed as a molar ratio. The thickness of the formed thin film was 50 nm.

The composition of the formed thin film was analyzed by ESCA as the Example 1, and the thin film included both Ti-N bonds and Ti-O bonds and the content of N atom forming the Ti-N bond in the thin film was 5.5 atom%.

Next, the formed thin film was structurally analyzed by X-ray diffraction, and an anatase TiO₂ crystal structure was observed. Based on these results, it was determined that a TiO₂:N film was formed.

Similar to the Example 5, as a result of continuous supply of the coating film forming gas to the apparatus for thermal CVD under atmospheric pressure after forming the thin film as above, no significant change was found in the gas pressure in the pipe supplying the coating film forming gas, and no deposit was found in the pipe.

### (Example 7)

A thin film was formed on a surface of a glass sheet in the same manner as the Example 5 other than the film deposition temperature at 850°C and the mixture ratio of each component in the coating film forming gas as titanium tetrachloride:ammonia:oxygen:hydrogen chloride = 1:0.9:9.1:0.05 expressed as a molar ratio. The thickness of the formed thin film was 150 nm. It is considered that the film deposition rate became larger than that in the Example 6 in which the coating film forming gas is identical due to the film deposition temperature of 850°C.

The composition of the formed thin film was analyzed by ESCA as the Example 1, and the thin film included both Ti-N bonds and Ti-O bonds and the content af N atom forming the Ti-N bond in the thin film was 0.1 atom%.

Next, the formed thin film was structurally analyzed by X-ray diffraction, and an anatase TiO₂ crystal structure was observed. Based on these results, it was determined that a TiO₂:N film was formed.

Similar to the Example 5, as a result of continuous supply of the coating film forming gas to the apparatus for thermal CVD under atmospheric pressure after forming the thin film as above, no significant change was found in the gas pressure in the pipe supplying the coating film forming gas, and no deposit was found in the pipe.

### (Example 8)

A thin film was formed on a surface of a glass sheet in the same manner as the Example 5 other than the film deposition temperature at 850°C and the mixture ratio of each component in the coating film forming gas as titanium tetrachloride:ammonia:oxygen:hydrogen chloride = 1:9.1:0.4:0.05 expressed as a molar ratio. The thickness of the formed thin film was 60 nm.

The composition of the formed thin film was analyzed by ESCA as the Example 1, and the thin film included both Ti-N bonds and Ti-O bonds and the content of N atom forming the Ti-N bond in the thin film was 3.1 atom%.

Next, the formed thin film was analyzed structurally by X-ray diffraction, and an anatase TiO₂ crystal structure was observed. Based on these results, it was determined that a TiO₂:N film was formed.

Similar to the Example 5, as a result of continuous supply of the coating film forming gas to the apparatus for thermal CVD under atmospheric pressure after forming the thin film as above, no significant change was found in the gas pressure in the pipe supplying the coating film forming gas, and no deposit was found in the pipe.

### (Example 9)

A thin film was formed on a surface of a glass sheet in the same manner as the Example 1 other than the film deposition temperature at 750°C, with the mixture ratio of each component in the coating film forming gas as titanium tetrachloride:ammonia:oxygen = 1:0.9:9.1 expressed as a molar ratio and the titanium tetrachloride concentration in the coating film forming gas as 1 mol%. The thickness of the formed thin film was 55 nm, and the film deposition rate was at 28 nm/second.

The composition of the formed thin film was analyzed by ESCA as the Example 1, and the thin film included both Ti-N bonds and Ti-O bonds.

Next, the formed thin film was analyzed structurally by X-ray diffraction, and an anatase TiO₂ crystal structure was observed. Based on these results, it was determined that a TiO₂:N film was formed.

Similar to the Example 5, as a result of continuous supply of the coating film forming gas to the apparatus for thermal CVD under atmospheric pressure after forming the thin film as above, the gas pressure in the pipe supplying the coating film forming gas showed a tendency to be gradually increasing. The pipe was taken apart to observe the inside after stopping the supply of the coating film forming gas, and deposits were found in the pipe.

### (Comparative Example 1)

A thin film was formed on a surface of a glass sheet in the same manner as the Example 5 other than the mixture ratio of each component in the coating film forming gas as titanium tetrachloride:ammonia:oxygen:hydrogen chloride = 1:0.9:9.1:20 expressed as a molar ratio. The thickness of the formed thin film was 10 nm, and it was decreased remarkably compared to that of Example 6 (the film deposition rate at about 20 nm/second) in which the molar ratios of ammonia and oxygen to titanium tetrachloride (0.9 for ammonia and 9.1 for oxygen) were almost identical. The film deposition rate calculated by the thickness of the obtained thin film and the speed of the mesh belt was about 4 nm/second.

Similar to the Example 5, as a result of continuous supply of the coating film forming gas to the apparatus for thermal CVD under atmospheric pressure after forming the thin film as above, no significant change was found in the gas pressure in the pipe supplying the coating film forming gas, and no deposit was found in the pipe.

### (Example 10)

A thin film was formed on a surface of a glass sheet in the same manner as the Example 5 other than the film deposition temperature at 700°C and the mixture ratio of each component in the coating film forming gas as titanium tetrachloride:ammonia:oxygen:hydrogen chloride = 1:0.9:9.1:2 expressed as a molar ratio. The thickness of the formed thin film was 40 nm and the film deposition rate calculated by the thickness and the speed of the mesh belt was about 16 nm/second.

The composition of the formed thin film was analyzed by ESCA as the Example 1, and the thin film included both Ti-N bonds and Ti-O bonds.

Next, the formed thin film was analyzed structurally by X-ray diffraction, and an anatase TiO₂ crystal structure was observed. Based on these results, it was determined that a TiO₂:N film was formed.

Similar to the Example 5, as a result of continuous supply of the coating film forming gas to the apparatus for thermal CVD under atmospheric pressure after forming the thin film as above, no significant change was found in the gas pressure in the pipe supplying the coating film forming gas, and no deposit was found in the pipe.

### (Example 11)

A thin film was formed on a surface of a glass sheet in the same manner as the Example 5 other than the film deposition temperature at 700°C and the mixture ratio of each component in the coating film forming gas as titanium tetrachloride:ammonia:oxygen:hydrogen chloride = 1:0.9:9.1:0.05 expressed as a molar ratio and the titanium tetrachloride concentration in the coating film forming gas as 3 mol%. The thickness of the formed thin film was 150 nm and the film deposition rate calculated by the thickness and the speed of the mesh belt was about 60 nm/second.

The composition of the formed thin film was analyzed by ESCA as the Example 1, and the thin film included both Ti-N bonds and Ti-O bonds.

Next, the formed thin film was analyzed structurally by X-ray diffraction, and an anatase TiO₂ crystal structure was observed. Based on these results, it was determined that a TiO₂:N film was formed.

Similar to the Example 5, as a result of continuous supply of the coating film forming gas to the apparatus for thermal CVD under atmospheric pressure after forming the thin film as above, no significant change was found in the gas pressure in the pipe supplying the coating film forming gas, and no deposit was found in the pipe.

### (Example 12)

A thin film was formed on a surface of a glass ribbon by in-bath CVD using the apparatus shown in Fig. 3. A thin film was formed on a surface of a glass ribbon in the same manner as the Example 3 other than the film deposition temperature at 680°C, and the coating film forming gas further including hydrogen chloride, with the mixture ratio of each component in the coating film forming gas as titanium tetrachloride:ammonia:oxygen:hydrogen chloride = 1:9.1:0.2:0.05 expressed as a molar ratio and the titanium tetrachloride concentration in the coating film forming gas as 1 mol%. The thickness of the formed thin film was 100 nm, and the film deposition rate calculated by the thickness and the travel speed of the glass ribbon was about 33.3 nm/second.

The composition of the formed thin film was analyzed by ESCA as the Example 1, and the thin film included both Ti-N bonds and Ti-O bonds.

Next, the formed thin film was analyzed structurally by X-ray diffraction. An anatase TiO₂ crystal structure was not observed, and a halo corresponding to an amorphous structure was observed. Based on these results, it was determined that a TiON film was formed.

Similar to the Example 5, as a result of continuous supply of the coating film forming gas to the apparatus for thermal CVD under atmospheric pressure after forming the thin film as above, no significant change was found in the gas pressure in the pipe supplying the coating film forming gas, and no deposit was found in the pipe.

### (Example 13)

A thin film was formed on a surface of a glass ribbon by in-bath CVD using the apparatus shown in Fig. 3. A thin film was formed on a surface of a glass ribbon in the same manner as the Example 3 other than the film deposition temperature at 680°C, with the mixture ratio of each component in the coating film forming gas as titanium tetrachloride:ammonia:oxygen = 1:0.9:9.1 expressed as a molar ratio and the titanium tetrachloride concentration in the coating film forming gas as 0.7 mol%. The thickness of the formed thin film was 80 nm, and the film deposition rate calculated by the thickness and the travel speed of the glass ribbon was about 27 nm/second.

The formed thin film was analyzed by ESCA as the Example 1, and the thin film included both Ti-N bonds and Ti-O bonds.

Next, the formed thin film was analyzed structurally by X-ray diffraction, and an anatase TiO₂ crystal structure was observed. Based on these results, it was determined that a TiO₂:N film was formed.

Similar to the Example 5, as a result of continuous supply of the coating film forming gas into the bath after forming the thin film as above, the gas pressure in the pipe supplying the coating film forming gas into the bath showed a tendency to be gradually increasing. The pipe was taken apart to observe the inside after stopping the supply of the coating film forming gas, and deposits were found in the pipe.

Results of the Examples 5 to 13 and the Comparative Example 1 are shown in Table 2 below.

**TABLE 2**

| | Mixture Ratio of each Component in Coating Film Forming Gas (Molar Ratio where TiCl₄ is 1) | | | TiCl₄ Concentration in Coating Film Foaming Gas (mol%) | Film Deposition Temperature (°C) | Film Thickness (nm) | Type of Thin Film | Content of N Atom Forming Ti-N Bond (atom%) | Gas Pressure Increase in Pipe/ Deposit in Pipe |
|---|---|---|---|---|---|---|---|---|---|
| | NH₃ | O₂ | HCl | | | | | | |
| Example 5 | 0.09 | 9.1 | 0.05 | 1 | 750 | 35 | TiO₂:N | 0.2 | Not Found/ Not Found |
| Example 6 | 0.9 | 9.1 | 0.05 | 1 | 750 | 50 | TiO₂:N | 5.5 | Not Found/ Not Found |
| Example 7 | 0.9 | 9.1 | 0.05 | 1 | 850 | 150 | TiO₂:N | 0.1 | Not Found/ Not Found |
| Example 8 | 9.1 | 0.4 | 0.05 | 1 | 850 | 60 | TiO₂:N | 3.1 | Not Found/ Not Found |
| Example 9 | 0.9 | 9.1 | 0 | 1 | 750 | 55 | TiO₂:N | --- | Gradual Increase/ Found |
| Comparative Example 1 | 0.9 | 9.1 | 20 | 1 | 750 | 10 | --- | --- | Not Found/ Not Found |
| Example 10 | 0.9 | 9.1 | 2 | 1 | 700 | 40 | TiO₂:N | --- | Not Found/ Not Found |
| Example 11 | 0.9 | 9.1 | 0.05 | 3 | 700 | 150 | TiO₂:N | --- | Not Found/ Not Found |
| Example 12 | 9.1 | 0.2 | 0.05 | 1 | 680 | 100 | TiON | --- | Not Found/ Not Found |
| Example 13 | 0.9 | 9.1 | 0 | 0.7 | 680 | 80 | TiO₂:N | --- | Gradual Increase/ Found |

### (Comparative Example 2)

It was attempted to form a thin film on a surface of a glass sheet in the same manner as the Example 5 other than the film deposition temperature at 750°C and the mixture ratio of each component in the coating film forming gas as titanium tetrachloride:ammonia:oxygen:hydrogen chloride = 1:0:9.1:0.05 expressed as a molar ratio. The formed film was, however, a film with a thickness too thin to carry out the composition analysis.

### (Example 14)

The photocatalytic reactivity of the TiON films formed in the Examples 5 to 8 was evaluated.

### (Hydrophilic Property)

After cleaning the glass sheets with thin films fabricated in the Examples 5 to 8 with an alkali solution and pure water, they were stored in a darkroom kept at steady temperatures and humidities of 20 ± 5°C in temperature and 50 ± 10% in relative humidity for at least 24 hours. Next, using a black light fluorescent lamp (FL20S BLB-A manufactured by Toshiba Lighting and Technology Corp.), ultraviolet rays having an ultraviolet intensity of 1.0 m W/cm² measured by an ultraviolet intensity inspector (UVR-2, with a photoreceptor UD-36, manufactured by Topcon Corp.) was irradiated to the glass sheets with thin films for one hour in the room kept at steady temperatures and humidities. The ultraviolet rays were irradiated from the direction of the thin films.

Ultimate contact angles on the thin films after irradiation of the ultraviolet rays were measured by a contact angle meter (CA-DT type manufactured by Kyowa Interface Science Co., Ltd.). The ultimate contact angles on the thin films of all the fabricated glass sheets with thin films fabricated in the Examples 5 to 8 were less than 5° (equal to or less than detection limit), and they showed favorable hydrophilic properties.

### (Photodecomposition Property)

As the photodecomposition properties of TiON films formed in the Examples 5 to 8, their methylene blue (MB) decomposition properties when light in the visible and ultraviolet regions was irradiated were evaluated.

Visible light of a wavelength in the range approximately from 420 nm to 520 nm was irradiated to the glass sheets with thin films fabricated in the Examples 5 to 8 through both a high pass filter cutting light of wavelengths equal to or less than about 420 nm (Colored Glass Filter L42, manufactured by Asahi Techno Glass Corp.) and a band pass filter transmitting light of wavelengths in a range approximately from 300 nm to 520 nm (Colored Glass Filter V42, manufactured by Asahi Techno Glass Corp.), using a halogen lamp (JCR 100V 300WX, manufactured by Philips) as a visible light source. The visible light was irradiated from the direction of the thin films.

After irradiating the visible light, MB decomposition rates were obtained in conformity with the wet decomposition performance testing method for photocatalytic products (updated on May 28th, 2004) established by the photocatalytic product forum. In order to evaluate the photodecomposition properties when irradiating light in the range from ultraviolet to visible regions, a halogen lamp (JCR 100V 300WX, manufactured by Philips) was employed for the light source and a band pass filter transmitting light of wavelengths in a range approximately from 300 nm to 520 nm (Colored Glass Filter V42, manufactured by Asahi Techno Glass Corp.) was employed. Results of the evaluation are shown in Table 4 below.

Next, ultraviolet light was irradiated to the glass sheets with thin films fabricated in the Examples 5 to 8 using a black light fluorescent lamp (FL20S ·BLB-A manufactured by Toshiba Lighting and Technology Corp.) as an ultraviolet light source. The ultraviolet light was irradiated from the direction of the thin films.

After irradiating the ultraviolet light, the MB decomposition rates were obtained in the same manner as the case of visible light irradiation. Results are shown in Table 4 below. As shown in Table 4, the photodecomposition properties responding to ultraviolet and visible light were observed in all TiO₂:N films obtained in the Examples 5 to 8.

**TABLE 3**

| | MB Decomposition Rate (nmol/L min) | |
|---|---|---|
| | Visible Light Irradiation | Ultraviolet Light Irradiation |
| Example 5 | 0.2 | 2.6 |
| Example 6 | 1.5 | 2.6 |
| Example 7 | 0.5 | 4.1 |
| Example 8 | 2.1 | 5.7 |

### (Antimicrobial Property)

Antimicrobial properties of the TiON films obtained in the Examples 7 and 8 were evaluated by the film method with UV irradiation (defined in JIS Z 2081) established by the Society of Industrial Technology

### Antimicrobial Articles.

After adhering a film having Staphylococcus aureus (NBRC 12732) as a testing microbial attached thereof onto the thin films of the glass sheets with thin films fabricated in the Examples 7 and 8, ultraviolet rays having an ultraviolet intensity of 0.25 mW/cm² measured by an ultraviolet intensity inspector (UVR-2, with a photoreceptor UD-36, manufactured by Topcon Corp.) were irradiated using a black light fluorescent lamp (FL20S BLB-A manufactured by Toshiba Lighting and Technology Corp.). They were irradiated from the direction of the adhered films, and the glass sheets with thin films were kept under a constant condition of a humidity of 95% and a temperature of 25°C. The number of microbials six hours after starting the ultraviolet rays irradiation was evaluated, and the number of microbials on the film surface was decreased to equal to or less than 1/10000 compared to that before the ultraviolet ray irradiation.

### (Example 15)

A thin film was formed on a surface of a glass sheet in the same manner as the Example 5 other than the film deposition temperature at 650°C, the coating film forming gas free from oxygen and the mixture ratio of each component in the coating film forming gas as titanium tetrachloride:ammonia:hydrogen chloride = 1:9.1:0.3 expressed as a molar ratio. The thickness of the formed thin film was 60 nm.

The composition of the formed thin film was analyzed by ESCA as the Example 1, and a peak that was considered to be derived from Ti-N bonds was observed, while no peak that can be considered to be derived from Ti-O bonds was observed. Based on this result, it was determined that a TiN film was formed on the surface of the glass sheet in the Example 15.

Similar to the Example 5, as a result of continuous supply of the coating film forming gas to the apparatus for thermal CVD under atmospheric pressure after forming the thin film as above, no significant change was found in the gas pressure in the pipe supplying the coating film forming gas, and no deposit was found in the pipe.

### (Example 16)

A thin film was formed on a surface of a glass sheet in the same manner as the Example 5 other than the film deposition temperature at 700°C, the coating film forming gas free from oxygen and the mixture ratio of each component in the coating film forming gas as titanium tetrachloride:ammonia:hydrogen chloride = 1: 9.1:0.05 expressed as a molar ratio. The thickness of the formed thin film was 90 nm.

The composition of the formed thin film was analyzed by ESCA as the Example 1, and a peak that was considered to be derived from Ti-N bonds was observed, while no peak that can be considered to be derived from Ti-O bonds was observed. Based on this result, it was determined that a TiN film was formed on the surface of the glass sheet in the Example 16.

Similar to the Example 5, as a result of continuous supply of the coating film forming gas to the apparatus for thermal CVD under atmospheric pressure after forming the thin film as above, no significant change was found in the gas pressure in the pipe supplying the coating film forming gas, and no deposit was found in the pipe.

### (Comparative Example 3)

Although it was attempted to form a thin film on a surface of a glass sheet in the same manner as the Example 15 other than the coating film forming gas free from hydrogen chloride, the formed film was a film with a thickness too thin to carry out the composition analysis.

### (Comparative Example 4)

It was attempted to form a thin film on a surface of a glass sheet in the same manner as the Example 16 other than the coating film forming gas free from hydrogen chloride. However, some time after starting the thin film formation, the gas pressure in the pipe supplying the coating film forming gas increased so rapidly that the coating film forming gas could not be kept supplying. The supply of the coating film forming gas was stopped and the pipe was taken apart to observe the inside. A large amount of deposit was found in the pipe, and the pipe was completely blocked by the deposit.

Results of the Examples 15 and 16 and the Comparative Examples 3 and 4 were shown in Table 4 below.

**TABLE 4**

| | Mixture Ratio of each Component in Coating Film Forming Gas (Molar Ratio where TiCl₄ is 1) | | | TiCl4 Concentration in Coating Film Coating Gas (mol%) | Film Deposition Temperature (°C) | Film Thickness (nm) | Type of Thin Film | Gas Pressure Increase in Pipe/ Deposit in Pipe |
|---|---|---|---|---|---|---|---|---|
| | NH3 | O₂ | HCl | | | | | |
| Example 15 | 9.1 | 0 | 0.3 | 1 | 650 | 60 | TiN | Not Found/ Not Found |
| Example 16 | 9.1 | 0 | 0.05 | 1 | 700 | 90 | TiN | Not Found/ Not Found |
| Comparative Example 3 | 9.1 | 0 | 0 | 1 | 650 | --- | --- | --- |
| Comparative Example 4 | 9.1 | 0 | 0 | 1 | 700 | --- | --- | Rapid Increase/ pipe Blockage |

### (Example 17)

A thin film was formed on a surface of a glass sheet in the same manner as the Example 5 other than the film deposition temperature at 650°C, the coating film forming gas free from hydrogen chloride and the mixture ratio of each component in the coating film forming gas as titanium tetrachloride:ammonia:oxygen = 1: 9.1:0.05 expressed as a molar ratio. The thickness of the formed thin film was 50 nm.

The composition of the formed thin film was analyzed by ESCA as the Example 1, and a peak that was considered to be derived from Ti-N bonds was observed, while no peak that can be considered to be derived from Ti-O bonds was observed. Based on this result, it was determined that a TiN film was formed on the surface of the glass sheet in the Example 17.

Similar to the Example 5, as a result of continuous supply of the coating film forming gas to the apparatus for thermal CVD under atmospheric pressure after forming the thin film as above, no significant change was found in the gas pressure in the pipe supplying the coating film forming gas, and no deposit was found in the pipe.

### (Example 18)

A thin film was formed on a surface of a glass ribbon in the same manner as the Example 12 other than the film deposition temperature at 680°C and the mixture ratio of each component in the coating film forming gas as titanium tetrachloride: ammonia:oxygen:hydrogen chloride = 1:0.009:9.1:0.05 expressed as a molar ratio and the titanium tetrachloride concentration in the coating film forming gas as 0.7 mol%. The thickness of the formed thin film was 50 nm.

The formed thin film was analyzed by ESCA as the Example 1, and the thin film included both Ti-N bonds and Ti-O bonds.

Next, the formed thin film was analyzed structurally by X-ray diffraction, and an anatase TiO₂ crystal structure was observed. Based on these results, it was determined that a TiO₂:N film was formed.

Similar to the Example 5, as a result of continuous supply of the coating film forming gas to the apparatus for thermal CVD under atmospheric pressure after forming the thin film as above, no significant change was found in the gas pressure in the pipe supplying the coating film forming gas, and no deposit was found in the pipe.

The invention may be embodied in other forms without departing from the spirit or essential characteristics thereof. The embodiments disclosed in this specification are to be considered in all respects as illustrative and not limiting. The scope of the invention is indicated by the appended claims rather than by the foregoing description, and all changes that come with the meaning and range of equivalency of the claims are intended to be embraced therein.

### Industrial Applicability

According to the present invention, a method of manufacturing a glass sheet with a thin film, having a titanium compound as its main component formed on the glass sheet, which is a manufacturing method preventing deterioration in quality of the thin film, such as incorporating an impurity or forming a pinhole, and enabling an excellent productivity, particularly a productivity when forming a thin film on a glass sheet having a large area, can be provided.

## Claims

1. A method of manufacturing a glass sheet with a thin film, comprising:
forming a thin film having titanium oxynitride (TiON), nitrogen doped titanium oxide (TiO₂:N) or titanium nitride (TiN) as its main component,
by supplying a coating film forming gas including a titanium containing compound, a nitrogen containing compound and an oxidizing gas,
on a surface of a glass sheet or a glass ribbon in a process of manufacturing a glass sheet at a temperature equal to or higher than a predetermined temperature.

2. The method of manufacturing a glass sheet with a thin film according to claim 1, wherein a thin film having titanium oxynitride as its main component is formed.

3. The method of manufacturing a glass sheet with a thin film according to claim 1, wherein the thin film is formed on the surface of the glass sheet or the glass ribbon at a temperature equal to or higher than 600°C.

4. The method of manufacturing a glass sheet with a thin film according to claim 1, wherein the titanium containing compound is a titanium containing inorganic compound.

5. The method of manufacturing a glass sheet with a thin film according to claim 4, wherein the titanium containing inorganic compound is titanium tetrachloride.

6. The method of manufacturing a glass sheet with a thin film according to claim 5, wherein a titanium tetrachloride content X₁ in the coating film forming gas is equal to or more than 0.1 mol%.

7. The method of manufacturing a glass sheet with a thin film according to claim 6, wherein the content X₁ is equal to or more than 0.5 mol%.

8. The method of manufacturing a glass sheet with a thin film according to claim 1, wherein the titanium containing compound is at least one selected from titanium alkoxide and a titanium chelate compound.

9. The method of manufacturing a glass sheet with a thin film according to claim 1, wherein the nitrogen containing compound is at least one selected from ammonia, amine and a hydrazine derivative.

10. The method of manufacturing a glass sheet with a thin film according to claim 9, wherein the nitrogen containing compound is ammonia.

11. The method of manufacturing a glass sheet with a thin film according to claim 1, wherein the oxidizing gas includes at least one selected from carbon dioxide, carbon monoxide, water and oxygen.

12. The method of manufacturing a glass sheet with a thin film according to claim 11, wherein the oxidizing gas includes at least one selected from water and oxygen.

13. The method of manufacturing a glass sheet with a thin film according to claim 11, wherein the oxidizing gas includes oxygen.

14. The method of manufacturing a glass sheet with a thin film according to claim 1, wherein the coating film forming gas includes air.

15. The method of manufacturing a glass sheet with a thin film according to claim 1,
wherein the titanium containing compound is titanium tetrachloride, and
the nitrogen containing compound is ammonia.

16. The method of manufacturing a glass sheet with a thin film according to claim 1,
wherein the titanium containing compound is titanium tetrachloride, and
the oxidizing gas includes oxygen.

17. The method of manufacturing a glass sheet with a thin film according to claim 16, wherein a ratio (X₃/X₁) of an oxygen content X₃ to a titanium tetrachloride content X₁ in the coating film forming gas is equal to or more than 0.4 expressed as a molar ratio.

18. The method of manufacturing a glass sheet with a thin film according to claim 17,
wherein the nitrogen containing compound is ammonia, and
a ratio (X₂/X₁) of an ammonia content X₂ to the titanium tetrachloride content X₁ in the coating film forming gas is equal to or more than 1 expressed as a molar ratio.

19. The method of manufacturing a glass sheet with a thin film according to claim 16, wherein a ratio (X₃/X₁) of an oxygen content X₃ to a titanium tetrachloride content X₁ in the coating film forming gas is equal to or more than 0.1 and less than 0.4 expressed as a molar ratio.

20. The method of manufacturing a glass sheet with a thin film according to claim 19,
wherein the nitrogen containing compound is ammonia, and
a ratio (X₂/X₁) of an ammonia content X₂ to the titanium tetrachloride content X₁ in the coating film forming gas is equal to or more than 1.3 expressed as a molar ratio.

21. The method of manufacturing a glass sheet with a thin film according to claim 16, wherein a ratio (X₃/X₁) of an oxygen content X₃ to a titanium tetrachloride content X₁ in the coating film forming gas is less than 0.1 expressed as a molar ratio.

22. The method of manufacturing a glass sheet with a thin film according to claim 21,
wherein the nitrogen containing compound is ammonia, and
a ratio (X₂/-X₁) of an ammonia content X₂ to the titanium tetrachloride content X₁ in the coating film forming gas is more than 9 expressed as a molar ratio.

23. The method of manufacturing a glass sheet with a thin film according to claim 1, wherein the coating film forming gas further includes a reaction inhibitor that inhibits a chemical reaction between the titanium containing compound and the nitrogen containing compound at the time before the coating film forming gas reaches to the surface.

24. The method of manufacturing a glass sheet with a thin film according to claim 23,
wherein the titanium containing compound is titanium tetrachloride,
the reaction inhibitor is hydrogen chloride, and
a ratio (X₄/X₁) of a hydrogen chloride content X₄ to a titanium tetrachloride content X₁ in the coating film forming gas is less than 20 expressed as a molar ratio.

25. The method of manufacturing a glass sheet with a thin film according to claim 23,
wherein the titanium containing compound is titanium tetrachloride, and
the nitrogen containing compound is ammonia.

26. The method of manufacturing a glass sheet with a thin film according to claim 25, wherein the oxidizing gas includes oxygen.

27. The method of manufacturing a glass sheet with a thin film according to claim 25,
wherein the reaction inhibitor is hydrogen chloride,
a ratio (X₄/X₁) of a hydrogen chloride content X₄ to a titanium tetrachloride content X₁ in the coating film forming gas is less than 20 expressed as a molar ratio, and
a ratio (X₂/X₁) of an ammonia content X₂ to the titanium tetrachloride content X₁ in the coating film forming gas is more than 9 expressed as a molar ratio.

28. The method of manufacturing a glass sheet with a thin film according to claim 1, wherein a film deposition rate of the thin film is equal to or more than 10 nm/second.

29. The method of manufacturing a glass sheet with a thin film according to claim 1, wherein the thin film is formed on the surface of the glass ribbon in a float bath.

30. A method of manufacturing a glass sheet with a thin film, comprising:
forming a thin film having titanium nitride as its main component,
by supplying a coating film forming gas including a titanium containing compound and a nitrogen containing compound,
on a surface of a glass sheet or a glass ribbon in a process of manufacturing a glass sheet at a temperature equal to or higher than a predetermined temperature,
wherein the coating film forming gas further includes a reaction inhibitor that inhibits a chemical reaction between the titanium containing compound and the nitrogen containing compound at the time before the coating film forming gas reaches to the surface.

31. The method of manufacturing a glass sheet with a thin film according to claim 30,
wherein the titanium containing compound is titanium tetrachloride,
the reaction inhibitor is hydrogen chloride, and
a ratio (X₄/X₁) of a hydrogen chloride content X₄ to a titanium tetrachloride content X₁ in the coating film forming gas is less than 20 expressed as a molar ratio.

32. The method of manufacturing a glass sheet with a thin film according to claim 30,
wherein the titanium containing compound is titanium tetrachloride, and
the nitrogen containing compound is ammonia.

33. The method of manufacturing a glass sheet with a thin film according to claim 30, wherein a film deposition rate of the thin film is equal to or more than 10 nm/second.

34. The method of manufacturing a glass sheet with a thin film according to claim 30, wherein the thin film is formed on the surface of the glass ribbon in a float bath.
